# EUROPEAN PATENT APPLICATION

(11) **EP 1 197 967 A2**
(43) Date of publication of application: **17.04.2002**
(21) Application number: 01307489.3
(22) Date of filing: 03.09.2001
(51) Int. Cl.: G11B 20/14, G11B 20/18

(54) **Data modulation and correction methods**

(30) Priority: 11.10.2000 KR 2000059840
(71) Applicant: SAMSUNG ELECTRONICS CO., LTD., Suwon-City, Kyungki-do (KR)
(72) Inventor: Shim, Jae-seong, Gwangjin-gu, Seoul (KR); Lee, Kyung-geun, 122-1002 Sibeom Hanshin, Seongnam-si, Gyeonggi-do (KR); Kim, Ki-hyun, Youngsan-gu, Seoul (KR); Park, Hyun-soo, Seocho-gu, Seoul (KR)
(74) Representative: Chugg, David John

(57) **Abstract**

A data modulation method resistant to channel distortion and a method for correcting error in data coded by the modulation method are provided. The data modulation method uses a run length limited (RLL) modulation code applied to write data to an optical storage medium, the RLL modulation code being expressed as RLL (*d*, *k, m, n, s*) with *s* = 2 or greater, where *d* is minimum run length, *k* is maximum run length, *m* is the data bit length before modulation, *n* is the codeword bit length after modulation, and *s* is the space length between codewords. The data modulation and correction methods can reduce a redundancy in physical address data written to an optical storage medium with improved detection performance resistant to disturbance.

## Description

The present invention relates to data modulation and correction methods, and more particularly, to a code modulation method for modulating data to be resistant to channel distortion and a method for correcting errors in detecting the data modulated by the modulation method.

With the increased recording density of optical storage media, track pitches of digital versatile disc random access memories (DVD-RAMs), recordable DVD (DVD-R), or DVD rewritable (DVD-RW) become narrow. Accordingly, introduction of crosstalk or noise from neighbor tracks and the amount of inter-symbol interference (ISI) from neighbor pits are increasing. This disturbance increases jitter of a radio frequency (RF) signal, particularly when an optical storage medium whose physical address is recorded as pits is accessed.

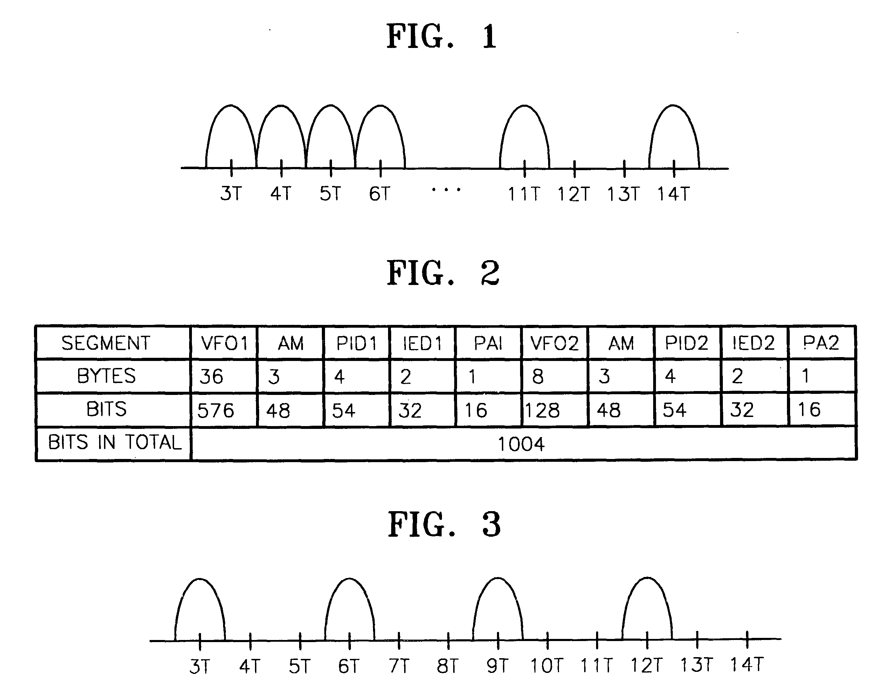

Run length limited (RLL) codes having limited maximum and minimum constraints are common data modulation codes for optical storage media. The minimum run length, which is denoted by parameter "d", greatly affects accuracy in detecting pits (or lands) in an optical disc and the recording density of that code. The maximum run length, which is denoted by parameter "k", is associated with code efficiency and code strategy. Common RLL codes include consecutive run lengths between the minimum and maximum run lengths. For example, for eight-to-fourteen modulation plus (EFM+) codes compatible with DVD family recording media with d=2 and k=10, 4T, 5T, ..., and 10T (where T is a reproduction clock) codes, excluding a sync code, exist between a minimum pit length of 3T and a maximum pit length of 11T. Figure 1 is a histogram of the run length distribution of the EFM+ codes. However, when jitter occurs in an RF signal being reproduced, due to any distortion in a channel, the 1T space codes of Figure 1 increase the likelihood of error occurring at a deviation of ∀0.5T.

Figure 2 is a table of the physical address format in the header field of a general DVD-RAM. For the general DVD-RAM, the same address data are written twice to the header field for high detection performance. The header field includes variable frequency oscillator (VFC1) data for a phase locked loop (PLL), address mark (AM) data, physical identification data (PID1), ID error detection data (IED1), and postamble data (PA1) for IED1 demodulation. VFO2, AM, PID2, IED2, and PA2, which have the same functions as those above, are also written to the header field. However, even though detection performance is improved, writing the physical address data based upon this RLL modulation code causes a redundancy problem.

With a view to solve or reduce the above-described problems, it is an aim of embodiments of the present invention to provide a data modulation method which can modulate data to be resistant to disturbance, and a method for correcting errors occurring in reading the data written by the modulation method.

According to an aspect of the present invention, there is provided a data modulation method using a run length limited (RLL) modulation code applied to write data to an optical storage medium, the RLL modulation code being expressed as RLL (*d*, *k*, *m*, *n*, *s*) with *s* = 2 or greater, where *d* is minimum run length, *k* is maximum run length, *m* is the data bit length before modulation, *n* is the codeword bit length after modulation, and s is the space length between codewords.

It is preferable that, in the RLL modulation code, the run length is one of 2, 5, 8, and 11, the number of lead zeros of a codeword is one of 1, 4, and 7, and the number of end zeros of a codeword is one of 1 and 4.

It is preferable that the RLL modulation code is applied to write address data to a physical sector of the optical storage medium, the address data being required for data access.

It is preferable that the RLL modulation code is pre-formed as pits in the optical storage medium to write and store importance information including copyrights.

It is preferable that the data modulation method comprises discarding codewords having a maximum run length from codewords modulated with the RLL modulation code for the purpose of generating a read clock signal and a synchronization clock signal.

It is preferable that the data modulation method comprises discarding codewords having a codeword digital sum (CDS) whose absolute value is relatively great, from codewords modulated with the RLL modulation code.

According to another aspect of the present invention, there is provided a data modulation method using a run length limited (RLL) modulation code applied to write data to an optical storage medium, the RLL modulation code being expressed as RLL (*d, k, m, n, s*), where *d* is minimum run length, *k* is maximum run length, *m* is the data bit length before modulation, *n* is the codeword bit length after modulation, and *s* is the space length between codewords, the data modulation method comprising: generating codewords satisfying an RLL (2, 11, 8, 27, 3) code; and removing codewords having a run length of 12T from the generated codewords, and creating a codeword table of the remaining codewords, where T is a reproduction clock signal.

It is preferable that the data modulation method further comprises: discarding codewords having a codeword digital sum (CDS) value whose absolute value is relatively great, from the codeword table; and arranging the remaining codewords in ascending order of the absolute value of the CDS for the purpose of reducing a direct current (DC) component of the codewords.

In another embodiment of the data correction method according to the present invention, there is provided a method for correcting data read from an optical storage medium after the data has been written to the optical storage medium with a run length limited (RLL) modulation code expressed as RLL (*d*, *k, m, n, s*), where *d* is minimum run length, *k* is maximum run length, *m* is the data bit length before modulation, *n* is the codeword bit length after modulation, and *s* is the space length between codewords, the method comprising: (a) counting the run lengths of code sequences read from the optical storage medium by detecting bit transitions in the code sequences, and if an N-th pit that does not comply with prescribed RLL coding rules is detected, checking the run lengths of following M pits; and (b) if the run length of any of the following M pits does not comply with the prescribed RLL coding rules, correcting the run length of the N-th pit according to the RLL coding rules.

It is preferable that step (b) comprises: if the run length of the N-th pit is s/2 less than a run length of the RLL code, correcting the N-th pit by adding s/2 to the run length of the N-th pit; and correcting the (N+1)th pit by subtracting s/2 from the run length of the (N+1)th pit.

It is preferable that step (b) comprises: if the run length of the N-th pit is s/2 greater than a run length of the RLL code, correcting the N-th pit by subtracting s/2 from the run length of the N-th pit; and correcting the (N+1)th pit by adding s/2 to the run length of the (N+1)th pit.

In the data correction method above, when s=3, step (b) preferably comprises: if the run length of the N-th pit is 1 less than a run length of the RLL code, correcting the N-th pit by adding 1 to the run length of the N-th pit; and correcting the (N+1)th pit by subtracting 1 from the run length of the (N+1)th pit.

When s=3, it is preferable that step (b) comprises: if the run length of the N-th pit is 1 greater than a run length of the RLL code, correcting the N-th pit by subtracting 1 from the run length of the N-th pit; and correcting the (N+1)th pit by adding 1 to the run length of the (N+1)th pit.

In still another embodiment of the data correction method according to the present invention, there is provided a method for correcting data read from an optical storage medium after the data has been written to the optical storage medium with a run length limited (RLL) modulation code expressed as RLL (*d, k, m, n, s*) with *d*=1 and *s*=3, where d is minimum run length, *k* is maximum run length, *m* is the data bit length before modulation, *n* is the codeword bit length after modulation, and *s* is the space length between codewords, the method comprising: (a) counting the run lengths of code sequences read from the optical storage medium by detecting bit transitions, determining whether the counted run lengths comply with prescribed RLL modulation rules, where the run lengths are expressed as iₙ₊₁ = iₙ+3 (n=1, 2, ...) with an initial run length of i₁=2, and if an N-th pit which does not equal to any of the run lengths iₙ is detected, checking the run lengths of the following M pits; and (b) if the run length of at least one of the M pits is not equal to the run lengths iₙ, correcting the run length of the N-th pit according to the prescribed RLL modulation rules.

It is preferable that step (b) comprises: (b1) correcting the run length of the N-th pit by adding a value to or subtracting a value from the run length of the N-th pit such that the run length of the N-th pit is equal to the run length iₙ having an absolute value closest to that of the N-th pit; and (b2) correcting the run length of the (N+1)th pit by subtracting from or adding to the run length of the N-th pit the value which is added or subtracted in step (b1).

In yet still another embodiment of the data correction method according to the present invention, there is provided a method for correcting data read from an optical storage medium after the data has been written to the optical storage medium with a run length limited (RLL) modulation code expressed as RLL (*d*, *k, m, n, s*) with *d*=1 and *s*=3, where *d* is minimum run length, *k* is maximum run length, *m* is the data bit length before modulation, *n* is the codeword bit length after modulation, and *s* is the space length between codewords, the method comprising: (a) counting the run lengths of code sequences read from the optical storage medium by detecting bit transitions, determining whether the counted run lengths comply with prescribed RLL modulation rules, where the run lengths are expressed as iₙ₊₁ = iₙ+3 (n=1, 2, ...) with an initial run length of i₁=1, and if an N-th pit which does not equal any of the run lengths iₙ is detected, checking the run lengths of the following M pits; and (b) if the run length of at least one of the M pits is not equal to the run lengths iₙ, correcting the run length of the N-th pit to comply with the prescribed RLL modulation rules.

It is preferable that step (b) comprises: (b1) correcting the run length of the N-th pit by adding a value to or subtracting a value from the run length of the N-th pit such that the run length of the N-th pit is equal to the run length iₙ having an absolute value closest to that of the N-th pit; and (b2) correcting the run length of the (N+1)th pit by subtracting from or adding to the run length of the N-th pit the value which is added or subtracted in step (b1).

For a better understanding of the invention, and to show how embodiments of the same may be carried into effect, reference will now be made, by way of example, to the accompanying diagrammatic drawings in which:
Figure 1 is a histogram of the run length distribution of EFM+ codes;
Figure 2 is a table of the physical address format in the header field of a general digital versatile disc random access memory (DVD-RAM) ;
Figure 3 is a histogram of the distribution of a codestream modulated by a data modulation method according to an embodiment of the present invention;
Figure 4 is a table of the codewords generated according to prescribed rules and classified by a codeword digital sum (CDS);
Figures 5A and 5B are tables of extended space run length limited (ES RLL) (2, 11, 8, 27, 3) modulation codewords from which codewords having a maximum pit length of 12T are discarded;
Figures 6A and 6B are tables of ES RLL (2, 11, 8, 27, 3) modulation codewords which have smaller CDS;
Figure 7 is a flowchart illustrating a method of correcting errors caused by jitter when data written to an optical storage medium with the ES RLL modulation code according to embodiment of the present invention are read;
Figure 8 is a flowchart illustrating an error correction method in detecting codewords modulated by an RLL (2, 11, 8, 27, 3) code;
Figure 9 shows the structure of the physical address data written to an optical storage medium for a conventional RLL code (a) and the ES RLL code according to embodiments of the present invention (b);
Figure 10 is a table showing the data format of the physical address sector of an optical storage medium to which the ES RLL code according to embodiments of the present invention is applied;
Figure 11A is a histogram of the ES RLL code stream according to embodiments of the present invention digitized using a conventional level slicer;
Figure 11B is a histogram of the ES RLL code stream according to embodiments of the present invention digitized using an SRC detector;
Figure 12 is a graph showing code stream detection performance with respect to circuit noise for the conventional method and that of embodiments of the present invention;
Figure 13 is a graph showing code stream detection performance with respect to asymmetry for the conventional method and that of embodiments of the present invention; and
Figure 14 is a graph showing code stream detection performance with respect to tangential skew of an optical storage medium for the conventional method and that of embodiments of the present invention.

A data modulation method according to the teachings of the present invention writes data to an optical storage medium using a modulation code spaced 2T or greater between pits, thereby reducing detection errors. Figure 3 is an exemplary histogram of the distribution of the codestream generated by a data modulation method according to an embodiment of the present invention. Use of codes spaced 2T or 3T between pits further improve data detection performance, compared to 1T spaced codes, for the same amount of jitter. Although the 2T or 3T spaced codes are disadvantageous in terms of recording density due to the increased code length, these codes are effective for important information such as physical address data written to a disc, in terms of improved detection performance with reduced errors in the presence of jitter.

The modulation method according to the present invention relates to generation of RLL(*d*, *k, m, n, s*) modulation codes with *s* = 2 or greater for improved detection performance, where *d* is minimum run length, *k* is maximum run length, *m* is the data bit length before modulation, *n* is the codeword bit length after modulation, and s is the space length between codewords Here, the run length means the number of consecutive "0"s between neighboring logical "1"s in binary code sequences.

RLL (2, 11, 8, 27, 3) codewords as shown in the histogram of Figure 3, which are generated with s=3, can be obtained according to the following rules:
(1) Run length ∈ {2, 5, 8, 11}
(2) Lead zero of a codeword ∈ {1, 4, 7}, and
(3) End zero of a codeword E {1, 4}.

According to Rule (1), the length of pits is one of 3T, 6T, 9T, or 12T. Rules (2) and (3) are established such that Rule (1) is satisfied when codewords are connected. For example, if the trailing end of a codeword has one zero, and the following codeword has one zero at its leading end, the run length of the two codewords becomes 2, satisfying the minimum run length defined by Rule (1). If the trailing end of a codeword has 4 zeros, and the following codeword has four zeros at its front end, the run length of the two codewords becomes 11, satisfying the maximum run length of Rule (1). According to this modulation, space between pits is extended by 3T in the present embodiment, so this modulation code is called "extended space modulation (ES RLL) code". The number of codewords satisfying Rules (1) through (3) is 298 in total, and the number of codewords having a maximum pit length of 12T is 63.

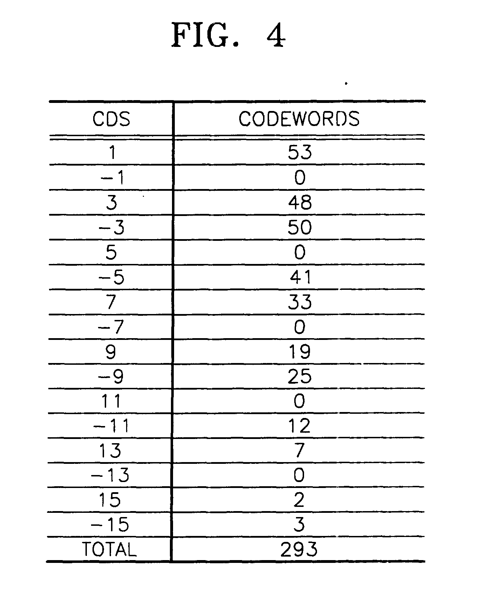

Figure 4 is a table of the codewords generated to comply with Rules (1) through (3), which are classified by a codeword digital sum (CDS). CDS refers to the result of summation of binary bits "1" and "0" in each codeword, wherein bits "0" are replaced by "-1" for the summation.

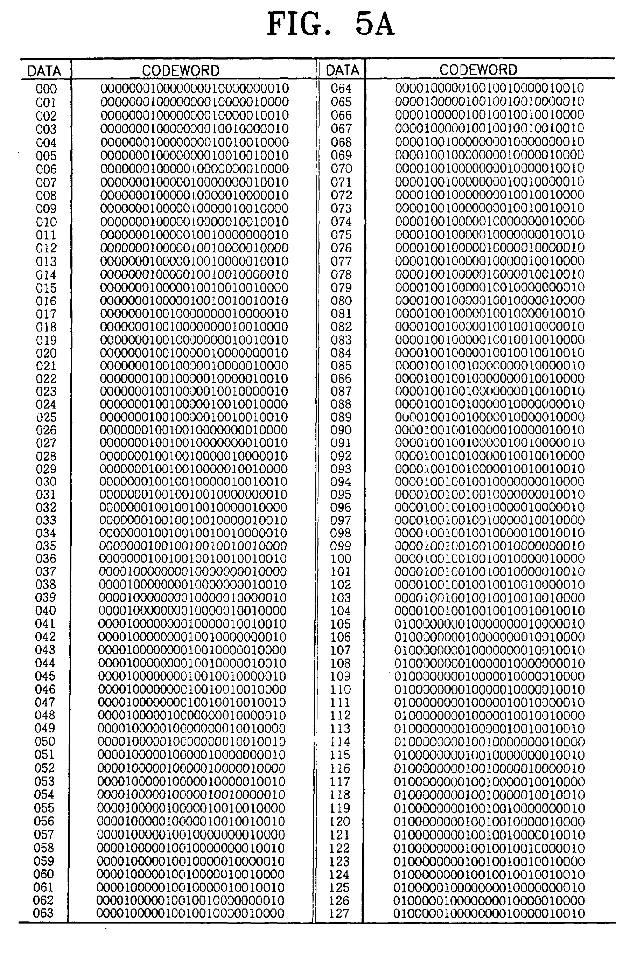

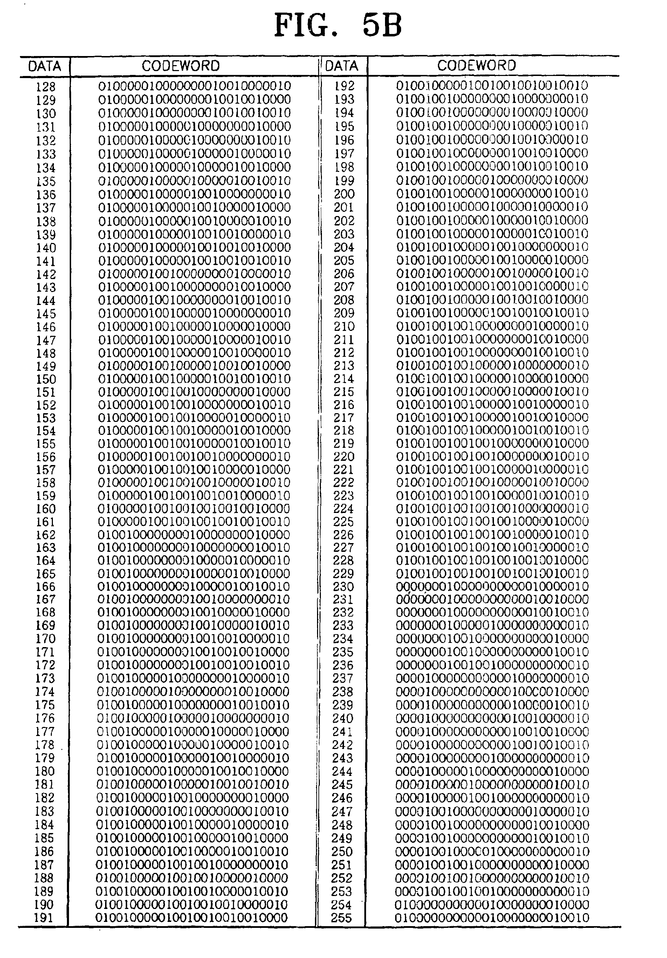

Figures 5A and 5B are tables of ES RLL (2, 11, 8, 27, 3) modulation codewords from which the 63 codewords having a maximum pit length of 12T are discarded to avoid a problem in the reproduction of a clock signal or of sync mismatching, wherein the discarded 63 codewords may include two pits having the maximum length of 12T.

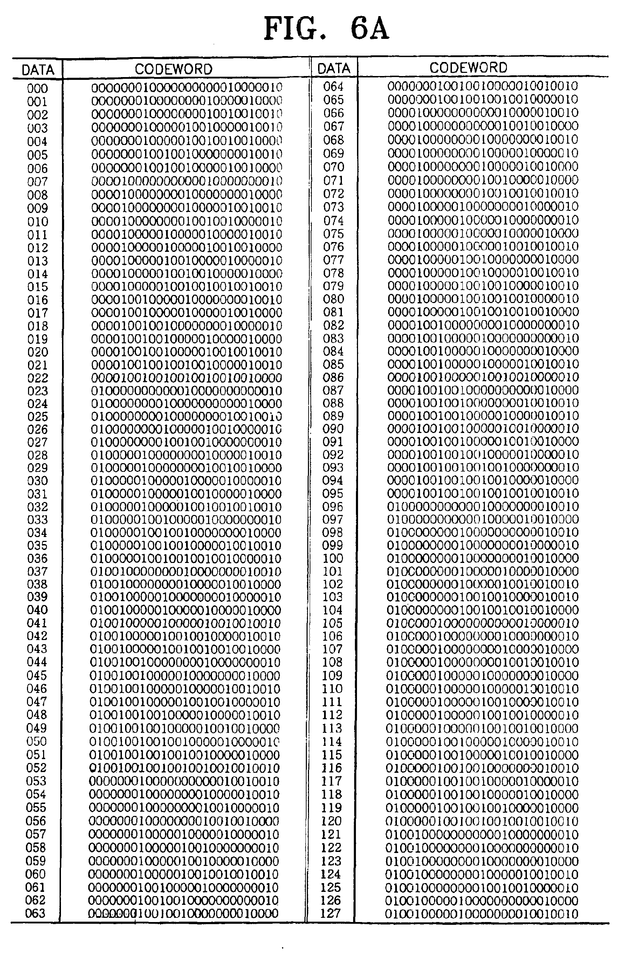

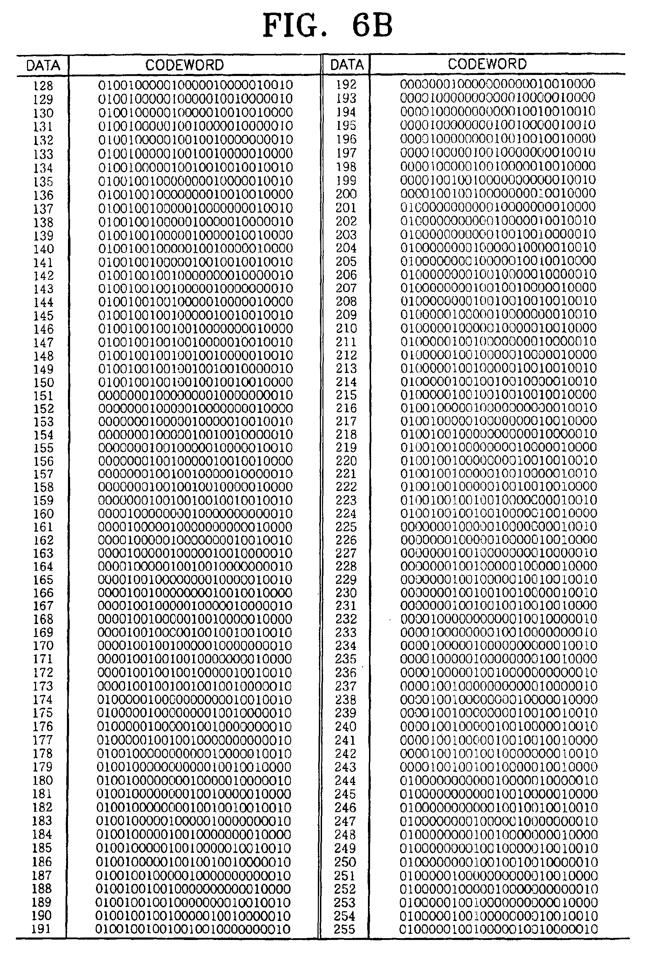

Figures 6A and 6B are tables of ES RLL (2, 11, 8, 27, 3) modulation codewords which have a smaller CDS. In other words, codewords having a relatively greater CDS are removed from the modulation codewords of Figures 6A and 6B so as to reduce the running digital sum (RDS) for direct current (DC) suppression control to the codewords.

The ES RLL modulation codes are pre-formed as pits in the physical address sector (header field) of an optical storage medium, to write physical address data for indicating data locations or other important information associated with, for example, copyrights.

An error correction method applied in detecting codewords modulated by the method described above will now be described.

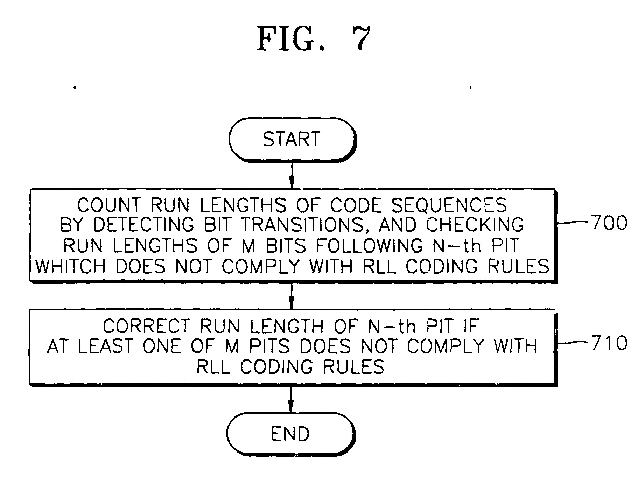

Figure 7 is a flowchart illustrating a method of correcting errors caused by jitter when data written to an optical storage medium with the ES RLL modulation code described above is read. In correcting errors in the data written with an RLL (*d, k*, *m*, *n,* s) code and read from an optical storage medium, first the run lengths of code sequences read from the optical storage medium are counted by detecting bit transitions therein. If an Nth-pit (or mark) which does not comply with the RLL coding rules is detected, the run lengths of the following M pits are checked (step 700). If the run length of any of the following M pits does not comply with the RLL coding rules, the run length of the N-th pit is corrected according to the RLL coding rules (step 710).

In step 710 of Figure 7, if the run length of the N-th pit is s/2 less than the run length of the RLL code, the N-th pit is corrected by adding s/2 to the run length of the N-th pit, and the (N+1)th pit is corrected by subtracting s/2 from the run length of the (N+1)th pit. If the run length of the N-th pit is s/2 greater than the run length of RLL (*d, k, s*), the N-th pit is corrected by subtracting s/2 from the run length of the N-th pit, and the (N+1)th pit is corrected by adding s/2 to the run length of the (N+1)th pit.

For an RLL (*d, k, s*) code with s=3, in step 710 of Figure 7, if the run length of the N-th pit is 1 less than the run length of the RLL code, the N-th pit is corrected by adding 1 to the run length of the N-th pit, and the (N+1)th pit is corrected by subtracting 1 from the run length of the (N+1)th pit. If the run length of the N-th pit is 1 greater than the run length of the RLL code, the N-th pit is corrected by subtracting 1 from the run length of the N-th pit, and the (N+1) th pit is corrected by adding 1 to the run length of the (N+1) th pit.

In correcting data read from an optical storage medium after having been written in an RLL (*d*, *k*, *m, n*, *s)* code with *d*=1 and *s*=3, where *d* is minimum run length, *k* is maximum run length, *m* is the data bit length before modulation, *n* is the codeword bit length after modulation, and s is the space length between codewords, the run lengths of code sequences read from the optical storage medium are counted by detecting bit transitions therein. Next, it is determined whether the counted run lengths comply with the RLL modulation rules, where the run lengths are expressed as i ₙ₊₁ = iₙ+3 (n=1, 2, ...) with an initial run length i₁=2. If an N-th pit which does not equal any of the run lengths iₙ is detected, the run lengths of the following M pits are checked. If the run length of at least one of the M pits is not equal to the run lengths iₙ, the run length of the N-th pit is corrected to comply with the RLL modulation rules.

In particular, the run length of the N-th pit is corrected by adding a value to or subtracting a value from the run length of the N-th pit such that the run length of the N-th pit is equal to the run length iₙ having an absolute value closest to that of the N-th pit, and is followed by correction in the run length of the (N+1)th pit. If a value is added to or subtracted from the run length of the N-th pit, the run length of the (N+1)th pit is corrected by subtracting the added value from or adding the subtracted value to the same.

As another embodiment, in correcting data read from an optical storage medium which was written in an RLL (*d*, *k, m, n, s)* code with *d*=1 and *s*=3, where *d* is minimum run length, *k* is maximum run length, *m* is the data bit length before modulation, *n* is the codeword bit length after modulation, and s is the space length between codewords, the run lengths of code sequences read from the optical storage medium are counted by detecting bit transitions therein. Next, it is determined whether the counted run lengths comply with the RLL modulation rules, where the run lengths are expressed as i ₙ₊₁ = iₙ+3 (n=1, 2, ...) with an initial run length of i₁=1. If an N-th pit which does not equal to the run lengths iₙ is detected, the run lengths of the following M pits are checked. If the run length of at least one of the M pits is not equal to the run lengths iₙ, the run length of the N-th pit is corrected to comply with the RLL modulation rules.

In particular, the run length of the N-th pit is corrected by adding a value to or subtracting a value from the run length of the N-th pit such that the run length of the N-th pit is equal to the run length iₙ having an absolute value closest to that of the N-th pit, and is followed by correction in the run length of the (N+1)th pit. If a value is added to or subtracted from the run length of the N-th pit, the run length of the (N+1)th pit is corrected by subtracting the added value therefrom or adding the subtracted value thereto.

In the data correction methods described above, if the run lengths of the M pits comply with the RLL coding rules, even if an error is detected in the N-th pit, the run length of the N-th pit is not corrected to prevent error propagation.

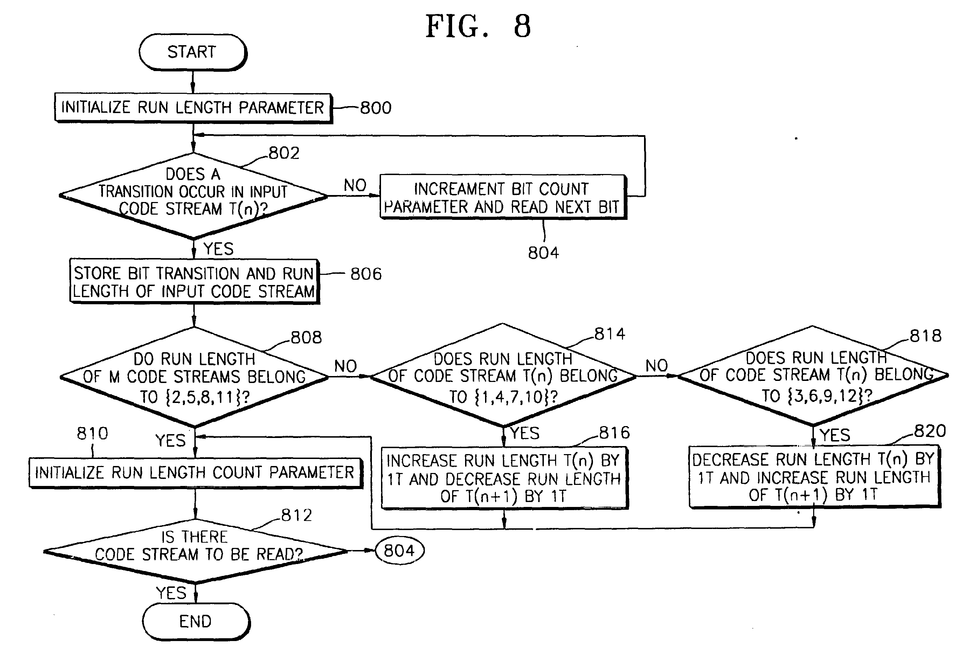

Figure 8 is a flowchart illustrating an error correction method in detecting a RLL (2, 11, 8, 27, 3) modulated code. When a code stream T(n) is input, a run length count parameter is initialized (step 800). Next, it is determined whether a transition occurs in a current bit of the input code stream (step 802). If no transition occurs in the current bit, a bit count parameter is incremented to read a next bit (step 804), and step 802 is performed again. If a transition is detected in step 802, the bit transition position and the run length of the input code stream T(n) are stored (step 806). The above steps are repeated for M code streams T(n+1), T(n+2), T(n+3), and T(n+4), following the code stream T(n), where M=4 in the present embodiment. Next, it is checked whether the run length of each of the M code streams belong to {2, 5, 8, 11} (step 808). In other words, it is determined whether the M code streams have 3T, 6T, 9T, or 12T signal. If all the run lengths of the code streams T(n+1), T(n+2), T(n+3), and T(n+4) belong to {2, 5, 8, 11}, the run length count parameter is initialized (step 810). Next, it is determined whether there is a code stream to be read (step 812). If there is no code stream to be read, the process stops. If there is a code stream to be read, the process goes to step 802. If it is determined in step 808 that the run length of at least one of the M code streams T(n+1), T(n+2), T(n+3), and T(n+4) does not belong to {2, 5, 8, 11}, it is determined whether the run length of the code stream T(n) stored in step 806 belongs to {1, 4, 7, 10} (step 814). If the run length of the code stream T(n) stored in step 806 belongs to {1, 4, 7, 10}, it means that the code stream T(n) has a run length 1T shorter than the desired run length with a pit signal of 2T, 5T, 8T, or 11T. The pit signal 2T, 5T, 8T, or 11T is corrected into 3T, 6T, 9T, or 12T, respectively, by increasing the run length of the code stream T(n). Subsequently, the code stream T(n+1) following the code stream T(n) is corrected by subtracting 1T from the run length of the code stream T(n+1) (step 816). If it is determined in step 814 that the run length of the code stream T(n) does not belong to {1, 4, 7, 10}, it is determined whether the run length of the code stream T(n) belongs to {3; 6, 9, 12} (step 818). If the run length of the code stream T(n) belongs to {3, 6, 9, 12}, it means that the code stream T(n) has a run length 1T longer than the desired run length with a pit signal of 4T, 7T, 10T, or 13T. The pit signal 4T, 7T, 10T, or 13T is corrected into 3T, 6T, 9T, or 12T, respectively, by reducing the run length of the code stream T(n). Subsequently, the code stream T(n+1) following the code stream T(n) is corrected by adding 1T to the run length of the code stream T(n+1) (step 820).

The data correction according to embodiments of the present invention is referred to as "SRC detection (Slide Run length Compensation looking forward pits)" because the correction is performed by checking pits for compliance with the applied coding rules.

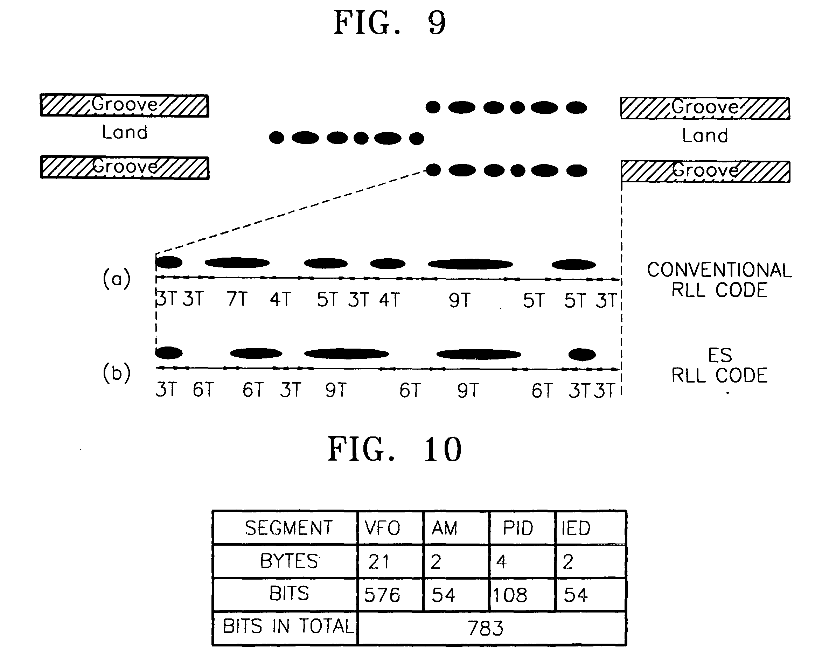

Figure 9 shows the format of the physical address data written to an optical storage medium for a conventional RLL code (a) and the ES RLL code according to the present invention (b). Figure 10 is a table showing the data format of the physical sector of an optical storage medium to which the ES RLL code according to the present invention is applied. As shown in Figure 10, the physical address data includes variable frequency oscillator (VFO) data for a phase locked loop (PLL), address mark (AM) data, physical identification data (PID), and ID error detection data (IED). Unlike a conventional physical address data format having 1004 bits in total, the constituent data are written once with a reduced total bit number of 783. As a result, there is an effect of 22% redundancy reduction in the physical address sector.

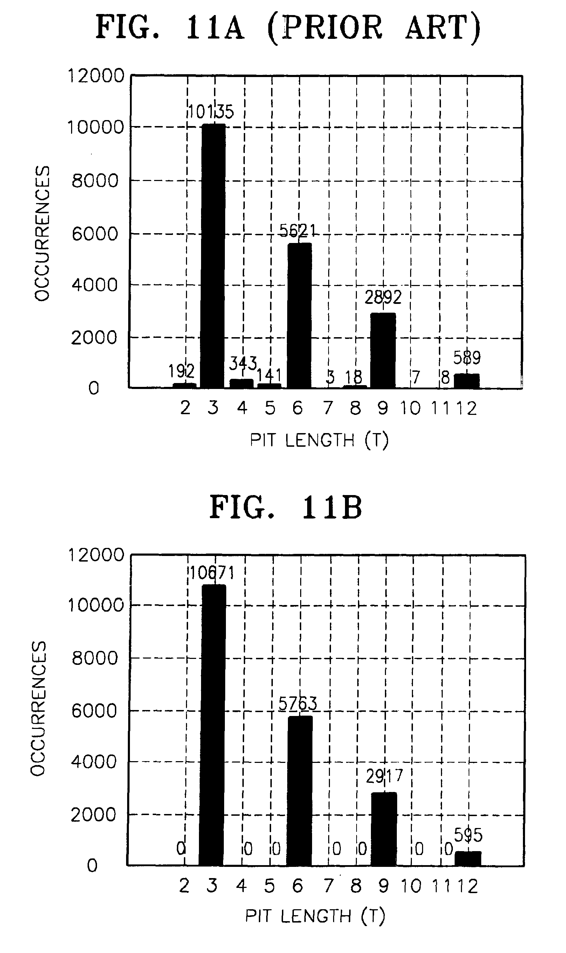

Figure 11A is a histogram of the ES RLL code stream according to embodiments of the present invention digitized using a conventional level slicer. As shown in Figure 11A, pits of the code stream range from 2T to 12T in length with 1T space. 192 pits of 2T, 10135 pits of 3T, 343 pits of 3T, 141 pits of 5T, 5621 pits of 6T, 3 pits of 7T, 18 pits of 8T, 2892 pits of 9T, 7 pits of 10T, 8 pits of 11T, and 589 pits of 12T are detected. The pits excluding 3T, 6T, 9T, and 12T pits correspond to errors.

Figure 11B is a histogram of the ES RLL code stream according to embodiments of the present invention digitized using an SRC detector. As shown in Figure 11B, 10671 pits of 3T, 5763 pits of 6T, 1917 pits of 9T, and 595 pits of 12T are detected. The errors shown in Figure 11A disappear.

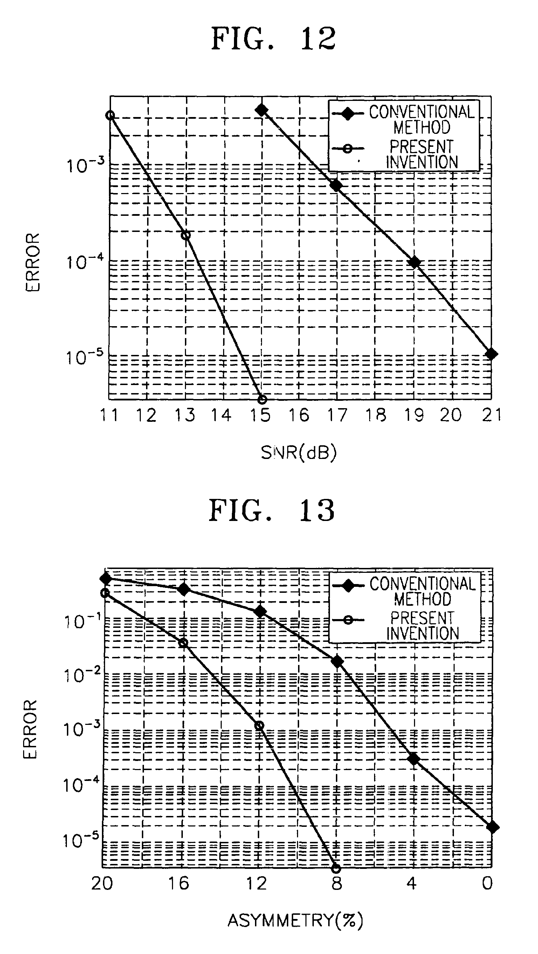

Figures 12 through 14 shows the difference in detection efficiency between different coding methods. Figure 12 is a graph showing code stream detection performance with respect to circuit noise for the conventional method and embodiments of the present invention. As shown in Figure 12, compared to the conventional method in which a level slicer is applied to the RLL code stream, when the SRC detection method is applied to the ES RLL code stream, detection performance is 5dB or greater improved.

Figure 13 is a graph showing code stream detection performance with respect to asymmetry for embodiments of the conventional method and the present invention. As shown in Figure 13, when the ES RLL code stream is detected using the SRC detector, an asymmetry margin is about 5% greater than the conventional method.

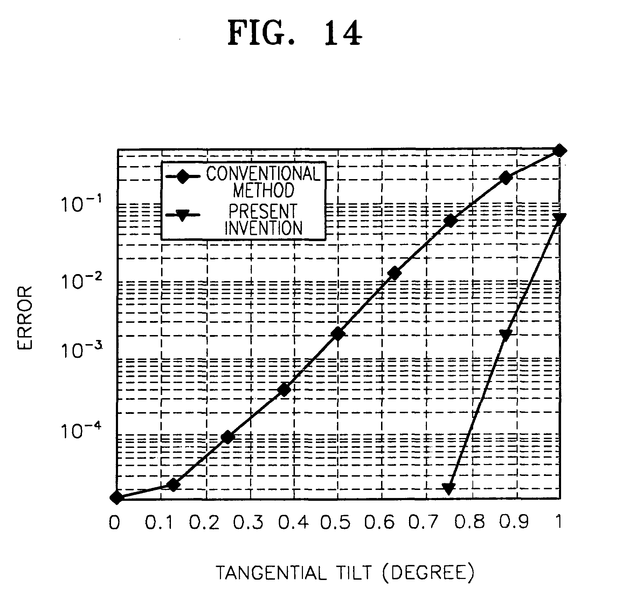

Figure 14 is a graph showing code stream detection performance with respect to the tangential skew of an optical storage medium for the conventional method and that embodiments of the present invention. As shown in Figure 14, when the ES RLL code stream is detected using the SRC detector, a tilt margin at an error rate of 10⁻⁴ is about 0.5 degrees greater than the conventional method.

As described above, the data modulation and correction methods according to the teachings of the present invention can reduce a redundancy in physical address data written to an optical storage medium with improved detection performance tolerant to disturbance.

While this invention has been particularly shown and described with reference to preferred embodiments thereof, it will be understood by those skilled in the art that various changes in form and details may be made therein without departing from the scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extend to any novel one, or any novel combination, of the features disclosed in this specification (including any accompanying claims, abstract and drawings), or to any novel one, or any novel combination, of the steps of any method or process so disclosed.

## Claims

1. A data modulation method using a run length limited (RLL) modulation code applied to write data to an optical storage medium, the RLL modulation code being expressed as RLL (*d*, *k, m, n, s*) with *s =* 2 or greater, where *d* is minimum run length, *k* is maximum run length, *m* is the data bit length before modulation, *n* is the codeword bit length after modulation, and s is the space length between codewords.

2. The data modulation method of claim 1, wherein, in the RLL modulation code, the run length is one of 2, 5, 8, and 11, the number of lead zeros of a codeword is one of 1, 4, and 7, and the number of end zeros of a codeword is one of 1 and 4.

3. The data modulation method of claim 1 or 2, wherein the RLL modulation code is applied to write address data to a physical sector of the optical storage medium, the address data being required for data access.

4. The data modulation method of claim 1, 2 or 3, wherein the RLL modulation code is pre-formed as pits in the optical storage medium to write and store importance information including copyrights.

5. The data modulation method of claim 1, 2, 3 or 4, comprising discarding codewords having a maximum run length from codewords modulated with the RLL modulation code for the purpose of generating a read clock signal and a synchronization clock signal.

6. The data modulation method of any preceding claim, comprising discarding codewords having a codeword digital sum (CDS) whose absolute value is relatively great, from codewords modulated with the RLL modulation code.

7. A data modulation method using a run length limited (RLL) modulation code applied to write data to an optical storage medium, the RLL modulation code being expressed as RLL (*d*, *k*, *m, n, s*), where *d* is minimum run length, *k* is maximum run length, *m* is the data bit length before modulation, *n* is the codeword bit length after modulation, and s is the space length between codewords, the data modulation method comprising:
generating codewords satisfying an RLL (2, 11, 8, 27, 3) code; and
removing codewords having a run length of 12T from the generated codewords, and creating a codeword table of the remaining codewords, where T is a reproduction clock signal.

8. The data modulation method of claim 7, further comprising:
discarding codewords having a codeword digital sum (CDS) value whose absolute value is relatively great, from the codeword table; and
arranging the remaining codewords in ascending order of the absolute value of the CDS for the purpose of reducing a direct current (DC) component of the codewords.

9. A method for correcting data read from an optical storage medium after the data has been written to the optical storage medium with a run length limited (RLL) modulation code expressed as RLL (*d, k, m, n, s*), where *d* is minimum run length, *k* is maximum run length, *m* is the data bit length before modulation, *n* is the codeword bit length after modulation, and *s* is the space length between codewords, the method comprising:
(a) counting the run lengths of code sequences read from the optical storage medium by detecting bit transitions in the code sequences, and if an N-th pit that does not comply with prescribed RLL coding rules is detected, checking the run lengths of following M pits; and
(b) if the run length of any of the following M pits does not comply with the prescribed RLL coding rules, correcting the run length of the N-th pit according to the RLL coding rules.

10. The method of claim 9, wherein step (b) comprises:
if the run length of the N-th pit is s/2 less than a run length of the RLL code, correcting the N-th pit by adding s/2 to the run length of the N-th pit; and
correcting the (N+1)th pit by subtracting s/2 from the run length of the (N+1)th pit.

11. The method of claim 9 or 10, wherein step (b) comprises:
if the run length of the N-th pit is s/2 greater than a run length of the RLL code, correcting the N-th pit by subtracting s/2 from the run length of the N-th pit; and
correcting the (N+1)th pit by adding s/2 to the run length of the (N+1)th pit.

12. The method of claim 9, 10 or 11, wherein, when s=3, step (b) comprises:
if the run length of the N-th pit is 1 less than a run length of the RLL code, correcting the N-th pit by adding 1 to the run length of the N-th pit; and
correcting the (N+1)th pit by subtracting 1 from the run length of the (N+1)th pit.

13. The method of claim 9, 10, 11 or 12, wherein, when s=3, step (b) comprises:
if the run length of the N-th pit is 1 greater than a run length of the RLL code, correcting the N-th pit by subtracting 1 from the run length of the N-th pit; and
correcting the (N+1)th pit by adding 1 to the run length of the (N+1)th pit.

14. A method for correcting data read from an optical storage medium after the data has been written to the optical storage medium with a run length limited (RLL) modulation code expressed as RLL (*d*, *k, m, n, s*) with *d*=1 and *s*=3, where *d* is minimum run length, *k* is maximum run length, *m* is the data bit length before modulation, *n* is the codeword bit length after modulation, and s is the space length between codewords, the method comprising:
(a) counting the run lengths of code sequences read from the optical storage medium by detecting bit transitions, determining whether the counted run lengths comply with prescribed RLL modulation rules, where the run lengths are expressed as i ₙ₊₁ = iₙ+3 (n=1, 2, ...) with an initial run length of i₁=2, and if an N-th pit which does not equal to any of the run lengths iₙ is detected, checking the run lengths of the following M pits; and
(b) if the run length of at least one of the M pits is not equal to the run lengths iₙ, correcting the run length of the N-th pit according to the prescribed RLL modulation rules.

15. The method of claim 14, wherein step (b) comprises:
(b1) correcting the run length of the N-th pit by adding a value to or subtracting a value from the run length of the N-th pit such that the run length of the N-th pit is equal to the run length iₙ having an absolute value closest to that of the N-th pit; and
(b2) correcting the run length of the (N+1)th pit by subtracting from or adding to the run length of the N-th pit the value which is added or subtracted in step (b1).

16. A method for correcting data read from an optical storage medium after the data has been written to the optical storage medium with a run length limited (RLL) modulation code expressed as RLL (*d*, *k, m, n, s*) with *d*=1 and *s*=3, where *d* is minimum run length, *k* is maximum run length, *m* is the data bit length before modulation, *n* is the codeword bit length after modulation, and *s* is the space length between codewords, the method comprising:
(a) counting the run lengths of code sequences read from the optical storage medium by detecting bit transitions, determining whether the counted run lengths comply with prescribed RLL modulation rules, where the run lengths are expressed as i ₙ₊₁ = iₙ+3 (n=1, 2, ...) with an initial run length of i₁=1, and if an N-th pit which does not equal any of the run lengths iₙ is detected, checking the run lengths of the following M pits; and
(b) if the run length of at least one of the M pits is not equal to the run lengths iₙ, correcting the run length of the N-th pit to comply with the prescribed RLL modulation rules.

17. The method of claim 16, wherein step (b) comprises:
(b1) correcting the run length of the N-th pit by adding a value to or subtracting a value from the run length of the N-th pit such that the run length of the N-th pit is equal to the run length iₙ having an absolute value closest to that of the N-th pit; and
(b2) correcting the run length of the (N+1)th pit by subtracting from or adding to the run length of the N-th pit the value which is added or subtracted in step (b1).
